Europäisches Patentamt

European Patent Office

Office européen des brevets

(19)

(11) Veröffentlichungsnummer: **0 230 508**
**B1**

(12) **EUROPÄISCHE PATENTSCHRIFT**

(45) Veröffentlichungstag der Patentschrift: **24.10.90**

(21) Anmeldenummer: **86110974.2**

(22) Anmeldetag: **08.08.86**

(51) Int. Cl.⁵: **H 01 L 21/76,** H 01 L 21/285, H 01 L 21/203, H 01 L 29/72, H 01 L 29/08

(54) Strukturierter Halbleiterkörper.

(30) Priorität: **20.12.85 DE 3545244**

(43) Veröffentlichungstag der Anmeldung:
**05.08.87 Patentblatt 87/32**

(45) Bekanntmachung des Hinweises auf die Patenterteilung:
**24.10.90 Patentblatt 90/43**

(84) Benannte Vertragsstaaten:
**DE FR GB**

(56) Entgegenhaltungen:
EP-A-0 021 393
EP-A-0 226 739
WO-A-85/02714
WO-A-85/03597
DE-A-1 942 838
FR-A-2 053 238
US-A-4 504 332

THIN SOLID FILM, Band 106, 1983, Seiten 3-136, Lausanne, CH; Y. OTA: "Silicon molecular beam epitaxy"

(73) Patentinhaber: **Licentia Patent-Verwaltungs-GmbH**
**Theodor-Stern-Kai 1**
**D-6000 Frankfurt/Main 70 (DE)**

(73) Patentinhaber: **TELEFUNKEN electronic GmbH**
**Theresienstrasse 2**
**D-7100 Heilbronn (DE)**

(72) Erfinder: **Kasper, Erich, Dr. rer. nat.**
**Osterholzweg 16**
**D-7914 Pfaffenhofen (DE)**
Erfinder: **Wörner, Klaus**
**Wasserfallstrasse 12**
**D-7105 Leingarten (DE)**

(74) Vertreter: **Amersbach, Werner, Dipl.-Ing. et al**
**Licentia Patent-Verwaltungs-GmbH Theodor-Stern-Kai 1**
**D-6000 Frankfurt 70 (DE)**

(56) References cited:

PATENT ABSTRACTS OF JAPAN, Band 7, Nr. 45 (E-160)1190r, 23. Februar 1983; & JP-A-57 197 833 (NIPPON DENKI K.K.) 04.12.1982

# EP 0 230 508 B1

(56) References cited:

**IEEE ELECTRON DEVICE LETTERS, Band EDL-6,
Nr. 6, Juni 1985, Seiten 288-290, IEEE, New York,
US; M.B. ROWLANDSON et al.: "A true
polysilicon emitter transistor"**

**Beschreibung**

Die Erfindung betrifft einen strukturierten Halbleiterkörper nach dem Oberbegriff des Patentanspruchs 1.

Ein derartiger Halbleiterkörper ist beispielsweise bekannt aus FR—A—20 53 238. Der bekannte Halbleiterkörper ist hergestellt nach dem Verfahren der differentiellen Epitaxie, wobei auf einem Substrat eine Oxidschicht aufgebracht und teilweise das Substrat wieder freigeätzt wird. Bei dem nachfolgenden epitaktischen Aufwachsen einer Siliziumschicht entsteht über dem Oxid polykristallines Silizium, über den freigsätzten Substratflächen monokristallines Silizium. Gemäß der FR—A—20 53 238 wird die Oxidschicht hoch dotiert. Durch die stark unterschiedlichen Diffusionswiderstände von polykristallinem und einkristallinem Silizium diffundiert der Dotierstoff aus der Oxidschicht fast ausschließlich in die polykristallinen Siliziumbereiche, so daß auf diese Weise unterschiedliche Dotierungen zur Bildung von pn-Sperrschichtübergängen vom monokristallinen zum polykristallinen Bereich erzeugt werden können. In monokristallinen Bereichen können durch übliche Verfahren (Selektives Ätzen, Dotieren, Diffusion) Halbleiterbauelemente erzeugt werden, wobei auch innerhalb der monokristallinen Bereiche verbliebene polykristalline dotierte Bereiche als vertikale Zuleitungen z.B. zu vergrabenen Schichten im Substrat benutzt werden können.

Aus Thin Solid Films, Band 106, 1983, Seite 3-136, insbesondere Seite 104 bis 106, ist speziell die Anwendung der Molekularstrahl Epitaxie MBE in Verbindung mit differentiellem Epitaxiewachstum beschrieben. Als Beispiel für ein damit hergestelltes Bauelement ist eine Diode angegeben, deren pn-Schichten zum einen durch einen monokristallinen Bereich in der Epitaxieschicht, zum anderen durch das hochdotierte Substrat gebildet sind. Der monokristalline Bereich in der Epitaxieschicht ist von polykristallinem Silizium geringer Leitfähigkeit umgeben. Die Kontaktierung des monokristallinen Bereichs erfolgt durch eine auf der polykristallinen Schicht aufgebrachte Metallisierung. Komplexere Bauelemente sind in diesem Zusammenhang nicht beschrieben.

Der vorliegenden Erfindung liegt die Aufgabe zugrunde, bei einem strukturierten Halbleiterkörper der eingangs genannten Art eine vorteilhafte Form der Kontaktierung anzugeben.

Diese Aufgabe wird gelöst durch die im kennzeichnenden Teil des Anspruchs 1 angegebenen Merkmale. Der Unteranspruch beschreibt eine spezielle Ausführungsform der Erfindung.

Ein erster Vorteil der Erfindung besteht darin, daß insbesondere bei der Herstellung von bipolaren Schaltkreisen die Maskierungssowie Kontaktierungsvorgänge in kostengünstiger Weise vereinfacht werden können.

Ein zweiter Vorteil besteht darin, daß besonders kleine Strukturen, z.B. kleiner 1µm für die Emitterund/oder Basisregion erzielt werden können. Dies erhöht die Packungsdichte und/oder die Schaltgeschwindigkeit der Schaltung.

Die Erfindung beruht auf der nachfolgend erläuterten Anwendung der sogenannten differentiellen Epitaxie auf Sihaltigem Material, die z.B. aus der Zeitschrift Journal of the Electrochemical Society 132, Seite 2227 (1985), bekannt ist. Dabei wird in einer Ultrahochvakuumanlage (Vakuum kleiner $10^{-9}$ mbar) mit Hilfe des Silizium-Molekularstrahlepitaxieverfahrens (Si-MBE) eine Si-Schicht aufgewachsen auf einem Si-Substrat, auf dem einkristalline Si-Bereiche sowie Siliziumdioxid ($SiO_2$)-Bereiche benachbart sind. Durch Wahl der Temperatur des Si-Substrates sowie des Vakuums, z.B. Art sowie Partialdruck von Restgasen, ist es gleichzeitig möglich, auf den einkristallinen Si-Bereichen einkristallines Si-Material aufzuwachsen während auf den $SiO_2$-Bereichen polykristallines Si-Material abgeschieden wird, dessen spezifische Leitfähigkeit einige Größenordnungen kleiner ist als diejenige des einkristallinen Si-Materials. Es entsteht ein genau bestimmbarer Übergang zwischen polykristallinem und einkristallinem Si-Material. Es ist möglich, die Wachstumsbedingungen so zu wählen, daß polykristallines und einkristallines Si-Material mit gleicher Schichtdicke abgeschieden werden. Dadurch entsteht an dem Übergang eine Stufe, daren Höhe lediglich von der Dicke der Siliziumdioxidschicht abhängt, die unter dem polykristallinen Silizium vorhanden ist.

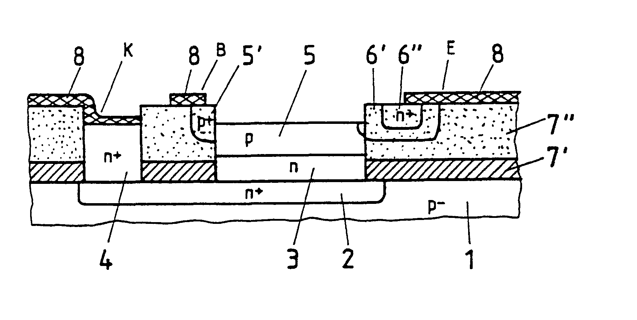

Diese Eigenschaften sind nutzbar zur Herstellung der folgenden beispielhaft gewhälten Halbleiterstrukturen, die anhand einer schematischen Zeichnung näher erläutert wird. Die Figur zeigt einen Querschnitt durch ein Ausführungsbeispiel.

Die Figur zeigt ein in der Halbleitertechnologie derzeit übliches $p^-$-dotiertes Si-Substrat 1, in dem eine $n^+$-dotierte vergrabene Halbleiterzone 2 vorhanden ist. Abschließend werden das Si-Substrat 1 und die Halbleiterzone 2 ganzflächig durch eine ungefähr 0,2 µm dicke $SiO_2$-Oxidschicht 7′ abgedeckt, die thermisch bei einer Temperatur von ungefähr 950°C hergestellt ist. Innerhalb das Bereiches der vergrabenen Halbleiterzone 2 werden nun zwei durch einen Abstand von ungefähr 3 µm benachbarte Fenster durch die Oxidschicht 7′ geätzt. Dabei besitzt das Kollektor-Fenster eine Größe von 3 µm×50 µm und das Basis/Emitter-Fenster eine Größe von 6 µm×50 µm. Anschließend wird ganzflächig das Si-MBE-Verfahren angewandt, wobei bei einer Substrattemperatur von 650°C durch Antimon (Sb) n-dotiertes Silizium abgeschieden wird. Dabei entstehen innerhlab der Fenster einkristalline Halbleiterbereiche 3, 4 mit einer Schichtdicke von 0,6 µm und einer Sb-Konzentration von $1 \times 10^{16}/cm^3$ und außerhalb der Fenster, auf der Oxidschicht 7′, polykristallines Silizium 7″ mit einer Schichtdicke von ebenfalls 0,6 µm. Aus den angegebenen Schichtdicken geht hervor, daß sich ein—und polykristalline Si-Bereiche in der dargestellten Weise berühren. Der Halbleiterbereich 4 wird nun $n^+$-dotiert, z.B. mit Arsen (As). Daraus entsteht der Kollektorkontakt. In dem Halbleiterbereich 3 wird eine eine ungefähr 0,3 µm dicke p-dotierte Halbleiterschicht 5 erzeugt, z.B. durch eine Bor (B)-Diffusion mit einer Konzen-

tration von $10^{18}$/cm³. Alternativ dazu ist es möglich, einen n-dotierten Bereich mit einer Dicke von 0,3 µm epitaktisch aufzuwachsen und anschließend den p-dotierten Bereich ebenfalls epitaktisch aufzuwachsen. In dem beispielhaft rechtsseitig dargestellten Bereich des polykristallinen Siliziums 7'' wird nun ein n⁺-dotierter Poly-Siliziumbereich 6' erzeugt z.B. durch eine Ionenimplantation mit As-Ionen. Es ist wichtig, daß dieser Poly-Siliziumbereich 6' so weit von dem angrenzenden einkristallinen Halbleiterbereich 5 entfernt ist, z.B. 1 µm, so daß dort eine Dotierstoffbelegung vermieden wird. Durch eine anschließende Nachdiffusion, z.B. bei einer Temperatur von ungefähr 1000°C, entsteht der eigentliche Anschluß 6' der Emitteranschluß, der mit dem angrenzenden p-dotierten Halbleiterbereich 5 einen pn-Übergang bildet.

Zwischen Kollektorbereich 4 und (Emitter-)Anschluß 6' ist noch ein Basis-Anschluß 5' vorhanden, der bei diesem Ausführungsbeispiel aus p⁺-dotiertem polykristallinem Silizium 7'' besteht. Alternativ dazu ist es möglich, den Basis-Anschluß durch einen p-dotierten Einkristall-Halbleiterbereich herzustellen, wie dieses in der eingangs erwähnten Patentanmeldung beschrieben ist.

Es sind einkristalline unterschiedlich dotierte Halbleiterbereiche 3, 4, 5 entstanden, die durch Sperrbereiche getrennt sind, die polykristallines Silizium 7'' enthalten.

Die Herstellung der erforderlichen strukturierten Metallisierungen 8 erfolgt nach derzeit üblichen Verfahren, z.B. einem Lithographie- oder Lift-Off-Verfahren. Es entstehen die erforderlichen Kollektor-, Basis- und Emitterkontakte K, B, E.

Da das polykristalline Silizium 7'' eine spezifische elektrische Leitfähigkeit hat, die um einige Größenordnungen kleiner ist als diejenige der einkristallinen Si-Halbleiterbereiche, ist es überraschenderweise möglich, in kostengünstiger Weise passive elektrische Widerstände zu integrieren. Dazu wird beispielsweise während der n⁺-Dotierung das Emitters in dem polykristallinen Silizium 7'' ein Widerstandbereich, so stark dotiert, daß dort eine nutzbare Leitfähigkeit von $10^2$(Ohm cm)$^{-1}$ entsteht. Über die geometrischen Ansmaße (Länge, Breite, Dicke) ist dann ein gewünschter Widerstandswert von z.B. 10 kOhm einstellbar. Der Widerstandsbereich ist dann kontaktierbar durch metallische Leiterbahnen. Auf diese Weise ist in kostengünstiger Weise beispielsweise eine Kombination aus mehreren Transistoren und einem passiven Widerstandsnetzwerk als integriertes Bauelement herstellbar.

## Patentansprüche

1. Strukturierter Halbleiterkörper mit mehreren unterschiedlich dotierten Siliziumkristall-Halbleiterbereichen und diese lateral berührenden Sperrbereichen aus polykristallinem Silizium, die nach dem Verfahren der differentiellen Epitaxie auf einem Halbleitersubstrat gemeinsam aufgewachsen sind, dadurch gekennzeichnet, daß mindestens ein Anschluß zu einem einkristallinen Halbleiterbereich (5) als diesen berührender dotierter Bereich (6') in dem polykristallinen Silizium (7'') ausgebildet ist, wobei dieser Bereich einen Ort (6'') maximaler Dotierstoffkonzentration aufweist, der seitlich beabstandet von dem Übergang zwischen einkristallinem und polykristallinem Bereich liegt.

2. Halbleiterkörper nach Anspruch 1, dadurch gekennzeichnet, daß der dotierte polykristalline Bereich mit dem berührenden einkristallinen Halbleiterbereich einen pn-Übergang bildet und den Emitter eines aus den mehreren einkristallinen Halbleiterbereichen aufgebauten Transistors darstellt.

## Revendications

1. Corps semi-conducteur structuré, comportant plusieurs régions semi-conductrices, dopées différemment, en silicium cristallin, ainsi que des régions diélectriques qui les touchent latéralement, en silicium polycristallin, que l'on a fait croître ensemble sur un substrat semi-conducteur selon le procédé de l'épitaxie différentielle, caractérisé en ce qu'au moins une connexion d'une région semi-conductrice monocristalline (5) est réalisée dans le silicium polycristallin (7'') comme une région dopée (6') qui touche le région monocristalline et présente un endroit (6'') à concentration maximale en dopant, qui est situé latéralement à distance de la transition entre la région monocristalline et la région polycristalline.

2. Corps semi-conducteur selon la revendication 1, caractérisé en ce que la région polycristalline dopée forme une jonction un avec la région semi-conductrice monocristalline qui la touche et représente l'émetteur d'un transistor constitué des différentes régions semi-conductrices monocristallines.

## Claims

1. Structured semiconductor body with several differently doped silicon crystal semiconductor regions and barrier regions which contact these laterally, are of polycrystalline silicon and which have been grown together on a semiconductor substrate by the method of the differential epitaxy, characterised thereby, that at least one connection to a monocrystalline semiconductor region (5) is constructed as a doped region (6'), which contacts this, in the polycrystalline silicon (7''), wherein this region displays a location (6'') of maximum doping substance concentration, which lies laterally spaced from the transition between the monocrystalline and the polycrystalline region.

2. Semiconductor body according to claim 1, characterised thereby, that the doped polycrystalline region forms a pn-junction with the contacting monocrystalline semiconductor region and represents the emitter of a transistor built up of the several monocrystalline semiconductor regions.